# FASCICULE DE BREVET EUROPEEN

(11) **EP 4 518 618 B1**
(45) Date de publication et mention de la délivrance du brevet: **08.04.2026**
(21) Numéro de dépôt: 24197626.5
(22) Date de dépôt: 30.08.2024
(51) Int. Cl.: H10H 29/01, H10K 59/38, H10H 29/85

(54) **PROCEDE DE FABRICATION D'UN DISPOSITIF OPTOELECTRONIQUE A CONVERSION DE COULEUR, COMPORTANT UNE ETAPE DE POLARISATION D'UNE COUCHE ELECTRET DE MANIERE LOCALISEE AU MOYEN DES ELECTRODES SUPERIEURES DES DIODES**
VERFAHREN ZUR HERSTELLUNG EINER OPTOELEKTRONISCHEN FARBKONVERSIONSVORRICHTUNG MIT EINEM POLARISATIONSSCHRITT EINER ELEKTRETSCHICHT, DIE DURCH DIE OBEREN DIODENELEKTRODEN LOKALISIERT IST
METHOD FOR MAKING A COLOR-CONVERTED OPTOELECTRONIC DEVICE, COMPRISING A STEP OF LOCALLY BIASING AN ELECTRET LAYER WITH THE UPPER ELECTRODES OF THE DIODES

(30) Priorité: 04.09.2023 FR 2309260
(43) Date de publication de la demande: 05.03.2025
(73) Titulaire: Commissariat à l'Energie Atomique et aux Energies Alternatives, 75015 Paris (FR)
(72) Inventeur: TEMPLIER, François, 38054 Grenoble cedex 09 (FR); ALTAZIN, Stéphane, 38054 Grenoble cedex 09 (FR); SUHM, Aurélien, 38054 Grenoble cedex 09 (FR); BILDE, Jérémy, 38054 Grenoble cedex 09 (FR); QUESNEL, Etienne, 38054 Grenoble cedex 09 (FR)
(74) Mandataire: Santarelli

(56) Documents cités:
- US-A1- 2016 190 110
- US-A1- 2022 154 915

## Description

### DOMAINE TECHNIQUE

Le domaine de l'invention est celui des procédés de fabrication des dispositifs optoélectroniques comportant une matrice de diodes d'émission ou de détection d'un rayonnement électroluminescent, associée à des portions de conversion de couleur. L'invention trouve une application notamment dans les écrans d'affichage et les projecteurs d'images.

### ÉTAT DE LA TECHNIQUE ANTÉRIEURE

Il existe des dispositifs optoélectroniques comportant une matrice de diodes électroluminescentes identiques recouvertes au moins en partie par des portions de conversion de couleur. De tels dispositifs optoélectroniques peuvent former des écrans d'affichage ou des systèmes de projection d'images comportant une matrice de pixels lumineux de différentes couleurs.

Dans un tel dispositif optoélectronique, chaque pixel lumineux comporte une ou plusieurs diodes électroluminescentes associées à une portion de conversion de couleur. Dans le but d'obtenir des pixels lumineux adaptés à émettre des rayonnements lumineux de différentes couleurs, par exemple bleues, vertes ou rouges, les diodes électroluminescentes peuvent être adaptées à émettre toute une même lumière, par exemple bleue, et les pixels verts et rouges comportent des portions de conversion de lumière adaptées à absorber au moins en partie la lumière bleue incidente, et à émettre en réponse une lumière verte ou une lumière rouge.

Les diodes électroluminescentes sont donc de préférence identiques entre elles, et émettent un rayonnement lumineux de même longueur d'onde. Elles peuvent être formées à base d'un matériau semiconducteur comprenant des éléments de la colonne III et de la colonne V du tableau périodique, tel qu'un composé III-V, notamment le nitrure de gallium (GaN), le nitrure d'indium et de gallium (InGaN) ou le nitrure d'aluminium et de gallium (AlGaN). Elles sont agencées de manière à former une matrice de diodes électroluminescentes présentant une face avant au travers de laquelle est transmis le rayonnement lumineux généré.

Les portions de conversion de lumière peuvent être formés d'une matrice liante comportant des particules d'un matériau photoluminescent tel que le grenat d'yttrium et d'aluminium (YAG, pour *Yttrium Aluminium Garnet,* en anglais) activé par l'ion cérium YAG:Ce. Les particules photoluminescentes peuvent également être des boîtes quantiques (*quantum dots,* en anglais), c'est-à-dire sous la forme de nanocristaux semiconducteurs dont le confinement quantique est sensiblement tridimensionnel.

Le procédé de fabrication peut comporter le dépôt puis la structuration d'une couche photoluminescente pour former des premières portions de conversion de lumière, par exemple adaptées à convertir le bleu en rouge. Ces étapes sont effectuées à nouveau pour former des deuxièmes portions de conversion de lumière, par exemple adaptées à convertir le bleu en vert. Cependant, ce procédé présente l'inconvénient d'être peu adapté aux matrices de diodes à faible pas de pixels, par exemple de l'ordre de 5 µm, dans la mesure où des problèmes d'alignement ou de recouvrement des portions de conversion de lumière les unes par les autres peuvent être présents.

Le document WO2014/136023 décrit un autre procédé de fabrication, qui utilise une couche électret recouvrant la matrice de diodes. Le procédé comprend tout d'abord une étape d'inscription de motifs de charges électriques sur la face supérieure d'une couche diélectrique pour obtenir la couche électret. Pour cela, une pointe AFM (pour *Atomic Force Microscopy,* en anglais) polarisée est utilisée pour injecter localement les charges électriques. Puis, on effectue une étape de dépôt localisé de nanocristaux colloïdaux sur les motifs de charges électriques. Pour cela, la couche électret est mise au contact d'une solution colloïdale contenant les nanocristaux, lesquels viennent se déposer naturellement sur les motifs de charges électriques sous l'effet d'une force diélectrophorétique. Cependant, ce procédé présente notamment l'inconvénient de devoir d'injecter les charges électriques de manière séquentielle, en déplaçant la pointe AFM sur la surface de la face supérieure pour y former les motifs de charges électriques.

Le document WO2021/023656 décrit un procédé similaire, où les motifs de charges électriques sont définis par une technique d'estampage, c'est-à-dire par la mise au contact, avec une couche diélectrique destinée à former la couche électret, d'un tampon polarisé électriquement. La face inférieure du tampon est structurée pour former des dents polarisées, lesquelles viennent au contact de la couche diélectrique. On obtient ainsi la couche électret dont la face supérieure présente les motifs de charges électriques. Ensuite, on met la couche électret au contact d'une solution colloïdale, les nanocristaux présents se déposant alors sur les motifs de charges électriques par diélectrophorèse. Cependant, ce procédé présente notamment l'inconvénient de devoir positionner précisément le tampon vis-à-vis de la matrice de diodes. Or, l'incertitude de positionnement du tampon vis-à-vis de la matrice de diodes peut devenir problématique, en particulier pour les matrices de diodes à petit pas pixel, par exemple de l'ordre de 5 µm. En effet, cette incertitude ou imprécision de positionnement peut conduire à un mauvais positionnement des portions de conversion de lumière vis-à-vis des diodes, et donc à une dégradation des performances du dispositif optoélectronique.

Les document US 2022/154915 A1 et US 2016/190110 A1 décrivent un procédé de fabrication d'un dispositif optoélectronique comprenant une matrice de diodes et une matrice de portions de conversion de couleur.

### EXPOSÉ DE L'INVENTION

L'invention a pour objectif de remédier au moins en partie aux inconvénients de l'art antérieur, et plus particulièrement de proposer un procédé de fabrication d'un dispositif optoélectronique, où les portions de conversion de couleur sont réalisées de manière localisée et autoalignée sur les diodes correspondantes, tout en limitant le risque de désalignement vis-à-vis des diodes.

Pour cela, l'objet de l'invention est un procédé de fabrication d'un dispositif optoélectronique, lequel comporte : une matrice de diodes, présentant des faces arrière et avant opposées l'une à l'autre, la face avant étant destinée à recevoir ou transmettre un rayonnement lumineux ; et une matrice de portions de conversion de couleur disposée sur la face avant, dont des premières portions de conversion de couleur disposées en regard de diodes dites premières diodes de la matrice de diodes.

Le procédé comporte les étapes suivantes :
- fournir une structure optoélectronique comportant : la matrice de diodes ; au moins une couche d'électrode inférieure disposée au niveau de la face arrière et adaptée à polariser les diodes ; et des couches d'électrode supérieure disposées au niveau de la face avant et adaptées à polariser les diodes, dont des premières couches d'électrode supérieure adaptées à polariser les premières diodes et distinctes des autres couches d'électrode supérieure ;
- déposer une couche diélectrique, dont une face supérieure opposée à la face avant présente un potentiel de surface sensiblement nul, recouvrant la matrice de diodes et les couches d'électrode supérieure ;
- appliquer une différence de potentiel entre, d'une part une électrode temporaire disposée sur la couche diélectrique, et d'autre part les premières couches d'électrode supérieure, se traduisant par la formation de premiers motifs à potentiel de surface non nul dans la couche diélectrique située uniquement en regard des premières couches d'électrode supérieure ; puis retirer l'électrode temporaire ;
- réaliser les premières portions de conversion de couleur, par mise en contact de la couche diélectrique avec une première solution colloïdale contenant des premières particules photoluminescentes, lesquelles se déposent sur la couche diélectrique uniquement en regard des premiers motifs à potentiel de surface non nul, formant ainsi les premières portions de conversion de couleur.

Certains aspects préférés mais non limitatifs de ce procédé de fabrication sont les suivants.

La matrice de portions de conversion de couleur peut comporter des deuxièmes portions de conversion de couleur, distinctes des premières portions de conversion de couleur, et disposées en regard de diodes dites deuxièmes diodes de la matrice de diodes. De plus, la structure optoélectronique peut comporter, parmi les couches d'électrode supérieure, des deuxièmes couches d'électrode supérieure adaptées à polariser les deuxièmes diodes. Le procédé peut alors comporter, à la suite de la réalisation des deuxièmes portions de conversion de couleur, les étapes suivantes :
- appliquer une différence de potentiel entre, d'une part une électrode temporaire disposée sur la couche diélectrique, et d'autre part les deuxièmes couches d'électrode supérieure, se traduisant par la formation de deuxièmes motifs à potentiel de surface non nul dans la couche diélectrique située uniquement en regard des deuxièmes couches d'électrode supérieure ; puis retirer l'électrode temporaire ;
- réaliser les deuxièmes portions de conversion de couleur, par mise en contact de la couche diélectrique avec une deuxième solution colloïdale contenant des deuxièmes particules photoluminescentes distinctes des premières particules photoluminescentes, lesquelles se déposent sur la couche diélectrique uniquement en regard des deuxièmes motifs à potentiel de surface non nul, formant ainsi les deuxièmes portions de conversion de couleur.

Chaque couche d'électrode supérieure peut recouvrir entièrement la diode au-dessus de laquelle elle est située.

Lors de l'étape d'application d'une différence de potentiel entre l'électrode temporaire et les couches d'électrode supérieure, les couches d'électrode inférieure peuvent être non polarisées.

Lors de l'étape d'application d'une différence de potentiel entre l'électrode temporaire et les couches d'électrode supérieure, lesdites couches d'électrode supérieure alors polarisées peuvent être connectées entre elles.

Les diodes peuvent être au contact de couches d'électrode inférieure, les couches d'électrode inférieure étant distinctes les unes des autres, de manière à pouvoir activer chaque diode de manière sélective.

Le procédé peut comporter, après la réalisation des portions de conversion de couleur, une étape de connexion des premières et deuxièmes couches d'électrode supérieure entre elles.

Le procédé peut comporter, après la réalisation des portions de conversion de couleur, une étape de connexion de toutes les couches d'électrode supérieure entre elles.

Les diodes peuvent présenter des propriétés d'émission ou d'absorption d'un rayonnement lumineux identiques entre elles.

Les diodes peuvent être réalisées à base d'un composé semiconducteur organique ou inorganique.

L'invention porte également sur un procédé de fabrication collective et simultanée de plusieurs dispositifs optoélectroniques à partir d'un même substrat, comportant la mise en œuvre simultanée des étapes du procédé selon l'une quelconque des caractéristiques précédentes pour chaque dispositif optoélectronique.

Dans le cadre du procédé de fabrication collective, lors de l'étape d'application d'une différence de potentiel entre l'électrode temporaire et les couches d'électrode supérieure, l'électrode temporaire peut recouvrir continûment toutes les matrices de diodes. Par ailleurs, lesdites couches d'électrode supérieure alors polarisées peuvent être connectées entre elles.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

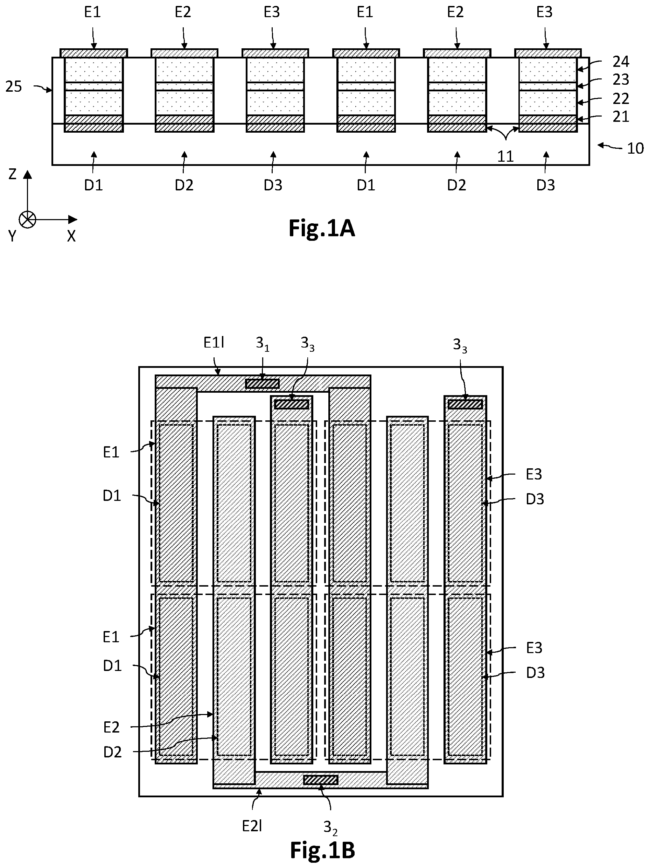

Les figures 1A à 1M illustrent différentes étapes d'un procédé de fabrication d'un dispositif optoélectronique selon un mode de réalisation, où la couche diélectrique électret est polarisée localement au moyen des couches d'électrode supérieures assurant la polarisation électrique des diodes lors de leur activation ;

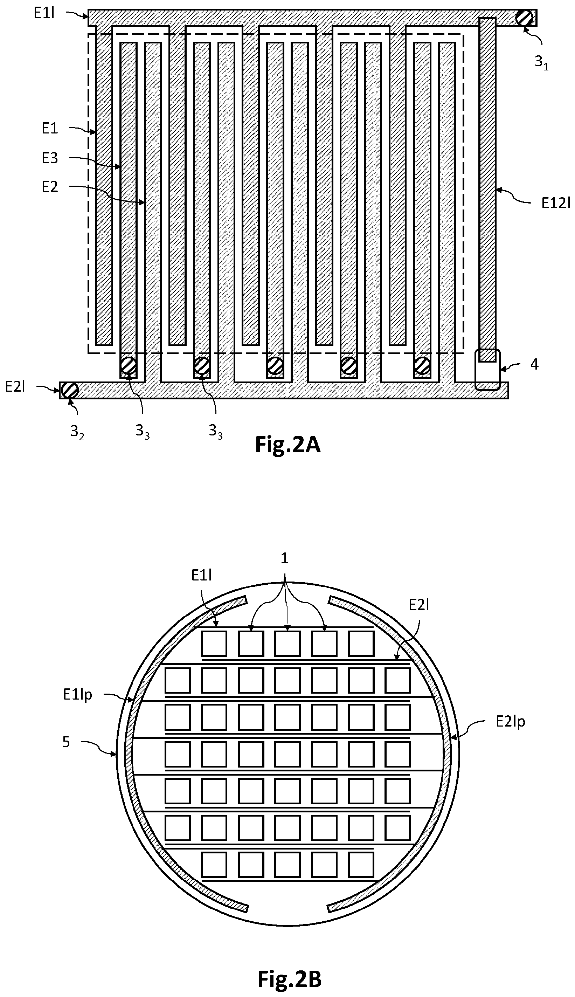

La figure 2A est une vue de dessus, schématique et partielle, d'un dispositif optoélectronique selon un autre mode de réalisation, où les couches d'électrode supérieure des diodes de type D1 sont connectées entre elles à l'échelle du dispositif optoélectronique, tout comme les couches d'électrode supérieure des diodes de type D2 ;
La figure 2B est une vue de dessus, schématique et partielle, de plusieurs dispositifs optoélectroniques selon un autre mode de réalisation, fabriqués de manière collective à partir d'un même substrat (*wafer*)*,* où les couches d'électrode supérieure des diodes d'un premier type de pixel lumineux sont connectées entre elles à l'échelle du substrat, tout comme les couches d'électrode supérieure des diodes d'un deuxième type de pixel lumineux ;

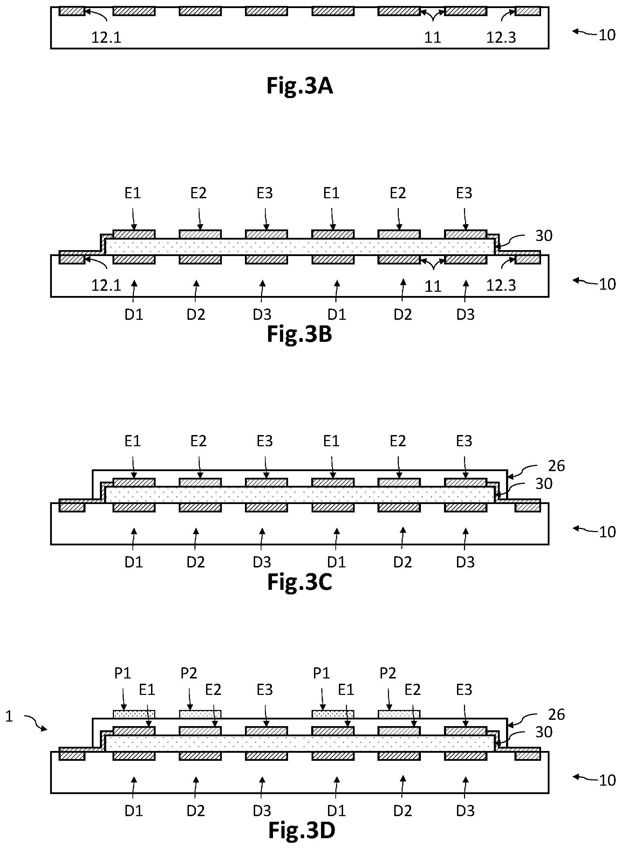

Les figures 3A à 3D illustrent différentes étapes d'un procédé de fabrication d'un dispositif optoélectronique selon un autre mode de réalisation, où les diodes sont des diodes électroluminescentes organiques.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un procédé de fabrication d'un dispositif optoélectronique comportant une matrice de diodes, dont au moins une partie des diodes est recouverte par des portions de conversion de couleur, de manière à former une matrice de pixels lumineux de différentes couleurs. Les diodes peuvent être des diodes émissives de sorte que le dispositif optoélectronique peut être par exemple un écran d'affichage, ou peuvent être des diodes détectrices de sorte que le dispositif optoélectronique peut être un photodétecteur matriciel. Par ailleurs, les diodes peuvent être des diodes électroluminescentes de type organique (OLED) ou inorganique (LED), ou encore des photodétecteurs organiques ou inorganiques.

La réalisation des portions de conversion de couleur est obtenue par le dépôt localisé de particules photoluminescentes sur une couche diélectrique électret où sont définis préalablement des motifs de potentiel de surface non nul. Comme détaillé par la suite, la formation de ces motifs de potentiel de surface est effectuée au moyen notamment des couches d'électrode supérieure qui assurent par ailleurs la polarisation électrique des diodes lors de leur activation. Comme détaillé par la suite, ces couches d'électrode supérieure peuvent être communes par type de pixel de couleur et sont distinctes d'un type de pixel de couleur à l'autre. En revanche, une fois que sont réalisées les portions de conversion de couleur, les couches d'électrode supérieure peuvent rester communes par type de pixel de couleur, voire peuvent être communes pour tous les pixels de couleur, ou peuvent être rendues distinctes par pixel. Par commune, on entend qu'elles sont connectées entre elles pour appliquer le même potentiel électrique.

D'une manière générale, une couche électret est une couche diélectrique contenant des charges électriques ou une polarisation dipolaire quasi-permanente. Aussi, la couche diélectrique électret présente, sur sa face supérieure, un potentiel de surface non nul. Cela se traduit par le fait que la couche diélectrique électret émet un champ électrique externe en l'absence d'un champ appliqué. Dans le cadre de l'invention, la face supérieure de la couche diélectrique électret présente des zones (appelées motifs) où le potentiel électrique de surface est non nul. Hors de ces motifs, le potentiel de surface est sensiblement nul.

Ainsi, lors de la réalisation des portions de conversion de couleur, les couches d'électrode supérieure sont distinctes, et réparties par type de pixel de conversion de couleur. Ainsi, on forme des motifs de potentiel de surface non nul où viendront ensuite se déposer naturellement, de manière localisée, des particules photoluminescentes par électrophorèse ou diélectrophorèse lors de la formation des portions de conversion de couleur. Aussi, les portions de conversion de lumière sont naturellement situées en regard (c'est-à-dire « à la perpendiculaire ») des motifs de potentiel de surface, et ne sont pas situées hors de ces motifs prédéfinis. Ce procédé permet alors de définir de manière précise les motifs de potentiel de surface sur la face supérieure de la couche diélectrique électret, quand bien même la matrice de diodes présente une dimension importante (notamment lorsqu'elle est réalisée en technologie de wafer 200 mm) et/ou que le pas pixel de la matrice de diodes est petit (par exemple de l'ordre de 5 µm).

Ainsi, à titre d'exemple, dans le cas d'une matrice de pixels rouges, verts, bleus (RVB, ou RGB en anglais pour *Red, Green, Blue*) où les diodes sont identiques et émettent toutes une même lumière bleue, lors de la réalisation des portions de conversion de couleur rouge, seules sont activées les couches d'électrode supérieure des pixels rouges, alors que les couches d'électrode supérieure des autres pixels (verts et bleus) ne sont pas activées. De même, lors de la réalisation des portions de conversion de couleur verte, seules sont activées les couches d'électrode supérieure des pixels vertes, alors que les couches d'électrode supérieure des autres pixels (rouges et bleus) ne sont pas activées.

Les portions de conversion de couleur sont formées de particules en au moins un matériau photoluminescent, et de préférence des nanoparticules dont une dimension maximale est comprise entre 0.2nm et 1000nm, par exemple comprise entre 0.2nm et 100nm, et par exemple entre 1nm et 30nm. La taille et/ou la composition des particules photoluminescentes sont choisies en fonction de la longueur d'onde de luminescence désirée. La forme des particules peut être quelconque, par exemple sphérique, anguleuse, aplatie, allongée...

Les particules photoluminescentes peuvent être des boîtes quantiques (*quantum dots,* en anglais), c'est-à-dire des nanocristaux semiconducteurs dont le confinement quantique est sensiblement tridimensionnel. La taille moyenne des boîtes quantiques peut alors être comprise entre 0,2nm et 50nm, par exemple entre 1nm et 30nm. Il peut également s'agir de nanoplaquettes (*nanoplatelets,* en anglais), c'est-à-dire des nanoparticules ayant une forme essentiellement bidimensionnelle. Aussi, la plus petite dimension (épaisseur) est inférieure aux deux autres dimensions de longueur et de largeur, de préférence d'un rapport au moins 1.5.

Les particules photoluminescentes peuvent notamment être formées d'au moins un composé semiconducteur, qui peut être choisi, par exemple, parmi le séléniure de cadmium (CdSe), le phosphore d'indium (InP), le phosphore de gallium et d'indium (InGaP), le sulfure de cadmium (CdS), le sulfure de zinc (ZnS), l'oxyde de cadmium (CdO) ou de zinc (ZnO), le séléniure de zinc et de cadmium (CdZnSe), le séléniure de zinc (ZnSe) dopé par exemple au cuivre ou au manganèse, le graphène ou parmi d'autres matériaux semiconducteurs pouvant convenir. Les nanoparticules peuvent également présenter une structure de type cœur/coquille, telle que CdSe/ZnS, CdSe/CdS, CdSe/CdS/ZnS, PbSe/PbS, CdTe/CdSe, CdSe/ZnTe, InP/ZnS ou autre. Les particules peuvent également présenter une structure cristalline pérovskite comportant des atomes tel que ceux listés pour les nanoparticules mais également Cs, Mn, Br.

Par ailleurs, les portions de conversion de lumière sont adaptées à convertir au moins en partie un rayonnement lumineux incident d'une première longueur d'onde λ₁ en un rayonnement lumineux de luminescence de plus grande longueur d'onde λ₂. A titre illustratif, elles peuvent être adaptées à absorber de la lumière bleue, c'est-à-dire dont la longueur d'onde est comprise entre 440nm et 490nm environ, et à émettre dans le vert, c'est-à-dire à une longueur d'onde comprise entre 495nm et 560nm environ, voire dans le rouge, c'est-à-dire à une longueur d'onde comprise entre 600nm et 650nm. Par longueur d'onde, on entend ici la longueur d'onde à laquelle le spectre d'émission présente un pic d'intensité.

A titre purement illustratif, les diodes peuvent être émissives et présenter un spectre d'émission dans le visible ou l'infrarouge (par exemple dans le NIR ou le SWIR), ou même ultraviolet (200-400 nm). Dans le cas d'une matrice de diodes émissives, le rayonnement lumineux incident est le rayonnement émis par les diodes, alors que dans le cas de photodiodes, il s'agit du rayonnement lumineux provenant d'un environnement extérieur et dirigé vers les photodiodes. Dans ce dernier cas, les diodes sont alors adaptées à absorber des rayonnements lumineux incidents de différentes longueurs d'onde toutes contenues dans un même spectre d'absorption prédéfini.

Les figures 1A à 1M illustrent différentes étapes d'un procédé de fabrication d'un dispositif optoélectronique 1 selon un mode de réalisation. Dans cet exemple, le dispositif optoélectronique 1 comporte une matrice de pixels lumineux de type RVB (rouge, vert, bleu). Chaque pixel est formé d'au moins une diode émissive électroluminescente (ici une diode par pixel). En variante, le dispositif optoélectronique 1 pourrait comporter une matrice de pixels lumineux d'autres types, par exemple de type RGB-IR (IR pour Infrarouge, *Infrared* en anglais). En variante également, les diodes peuvent être des photodiodes.

On définit ici et pour la suite de la description un repère direct tridimensionnel orthogonal XYZ, où les axes X et Y forment un plan principal dans lequel s'étend un substrat de commande 10, et où l'axe Z est orienté suivant l'épaisseur de la matrice de diodes en direction de la face avant. Les termes 'inférieur' et 'supérieur' sont définis par rapport à un positionnement croissant suivant la direction +Z.

En référence à la fig.1A, on fournit la matrice de diodes électroluminescentes. Dans cet exemple, les diodes sont réparties en trois types notés D1, D2, D3, selon le type de pixel lumineux auquel elles appartiennent, par exemple ici des pixels bleus pour les diodes D1, des pixels rouges pour les diodes D2, et des pixels verts pour les diodes D3. Les diodes reposent ici sur un substrat de commande 10, et sont polarisées électriquement ici par une ou plusieurs couches d'électrode inférieure 11 et par des couches d'électrode supérieure E1, E2, E3. D'autres configurations sont possibles, notamment dans le cas où le substrat de commande 10 est électriquement conducteur. La matrice de diodes présente une face arrière, par laquelle elle est assemblée et connectée au substrat de commande 10, et une face avant, opposée à la face arrière, qui est destinée à recevoir ou transmettre un rayonnement lumineux. Dans cet exemple où les diodes sont émissives, la face avant transmet le rayonnement lumineux émis par les diodes.

Dans cet exemple, le substrat de commande 10 assure plusieurs fonctions : le support mécanique de la matrice de diodes, la polarisation électrique des couches d'électrode supérieure E1, E2 lors des étapes de réalisation des portions de conversion de lumière P1, P2, et la polarisation électrique des diodes D1, D2, D3 lors du fonctionnement du dispositif optoélectronique. Il comporte ici un circuit de commande de type CMOS, et présente des plots de connexion électrique 11 qui affleurent la face supérieure et viennent au contact de couches d'électrode inférieure 21 des diodes D1, D2, D3. Ces couches d'électrode inférieure 21 sont ici des couches distinctes les uns des autres, dans le sens où chaque couche d'électrode inférieure 21 d'une diode est physiquement distincte de celle de la diode adjacente. Cette configuration est décrite en détail dans le document WO2017/194845 A1.

Les diodes D1, D2, D3 sont ici des diodes électroluminescentes inorganiques. Elles peuvent être réalisées de manière classique, par exemple par épitaxie de couches semiconductrices à partir d'un substrat de croissance, puis par report sur le substrat de commande 10. Chaque diode D1, D2, D3 peut être formée d'un empilement de : une portion semiconductrice inférieure 22 (orientée vers le substrat de commande 10) dopée d'un premier type de conductivité, par exemple de type p, en contact électrique avec une couche d'électrode inférieure 21; une zone active 23 où est émis le rayonnement lumineux de la diode électroluminescente ; et une portion semiconductrice supérieure 24 dopée d'un deuxième type de conductivité, par exemple de type n, en contact électrique avec une couche d'électrode supérieure E1, E2 ou E3. Les diodes D1, D2, D3 peuvent être réalisées à partir d'un même composé semiconducteur, par exemple à base d'un composé III-V tel que du GaN, InGaN, AlGaN.

De préférence, les diodes D1, D2, D3 sont structurellement identiques, de sorte que le rayonnement lumineux émis est identique d'une diode à l'autre en termes de longueur d'onde. Dans cet exemple, les diodes D1, D2, D3 sont adaptées à émettre un rayonnement lumineux dans le bleu, c'est-à-dire dont le spectre d'émission présente un pic d'intensité à une longueur d'onde comprise entre 440nm et 490nm environ.

La fig.1B est une vue de dessus de la matrice de diodes illustrée sur la fig.1A. Il s'agit évidemment d'un exemple car d'autres configurations sont possibles. Ici, chaque pixel RGB comporte trois diodes D1, D2, D3. Les couches d'électrode supérieure E1 destinées à polariser les diodes D1 s'étendent ici sur plusieurs diodes D1 adjacentes. Il en est de même pour les couches d'électrode supérieure E2 destinées à polariser les diodes D2 et pour les conductrices supérieures destinées à polariser les diodes D3. De préférence, les couches d'électrode supérieure E1 sont connectées entre elles par une bande conductrice latérale E1I. Les couches d'électrode supérieure E2 sont également connectées entre elles par une bande conductrice latérale E2I. Les couches d'électrode supérieure sont connectées au substrat de commande par des plots de connexion 3 (plot 3₁ pour les couches d'électrode E1, plot 3₂ pour les couches E2....), par exemple par des vias conducteurs qui s'étendent au travers du matériau diélectrique de remplissage 25 qui entoure les diodes D1, D2, D3.

De préférence, les couches d'électrode E1 recouvrent entièrement les diodes D1 dans le plan XY, tout comme les couches d'électrode E2 recouvrent entièrement les diodes D2, et les couches d'électrode E3 recouvrent entièrement les diodes D3. Evidemment, les couches d'électrode d'un même type (par ex. E1) ne s'étendent pas en regard des diodes des autres types (par ex. D2 et D3).

Les couches d'électrode inférieure et supérieure sont réalisées en un matériau électriquement conducteur. Les couches d'électrode inférieure 21 peuvent être réalisées en au moins un matériau métallique choisi parmi le Ti, le Ni, le Pt, le Sn, l'Au, l'Ag, l'Al, le Pd, le W, le Pb, le Cu, l'AuSn, le TiSn ou un alliage de ces éléments. Elles peuvent de préférence être réfléchissantes au rayonnement lumineux émis par les diodes, et peuvent ainsi être réalisées à base d'Ag. Par ailleurs, le matériau des couches d'électrode supérieure E1, E2, E3 est au moins en partie transparent au rayonnement lumineux émis par les diodes, et peut être par exemple de l'ITO (oxyde d'indium étain), voire des matériaux métalliques fins semi-transparents (par ex. Ag).

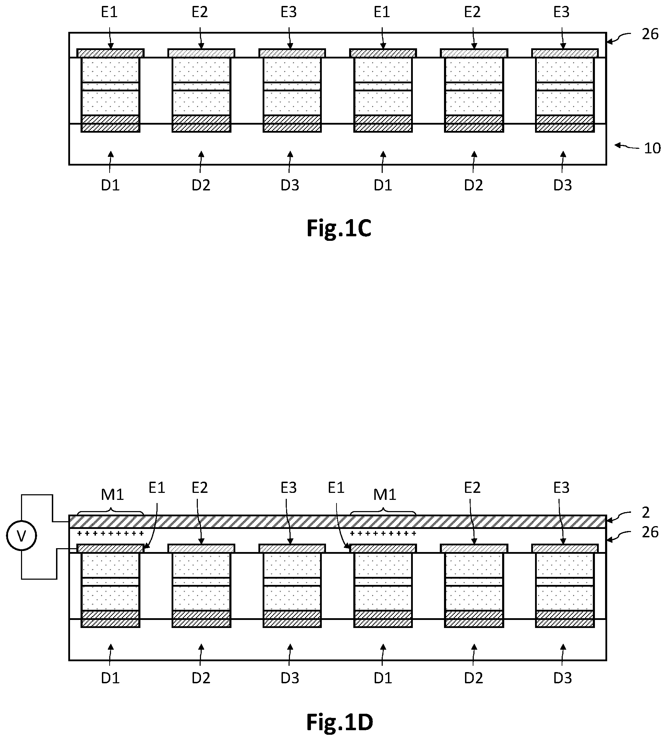

En référence à la fig.1C, on réalise ensuite une couche diélectrique 26 destinée à former la couche électret. La couche diélectrique 26 recouvre la matrice de diodes, et donc les couches d'électrode supérieure E1, E2 et E3. Elle présente initialement un potentiel de surface sensiblement nul, de sorte qu'on ne retrouve pas de motifs non souhaités de potentiel de surface non nul. La couche diélectrique 26 est réalisée en un matériau diélectrique, par exemple inorganique, tel qu'un oxyde, nitrure ou oxynitrure de silicium, par exemple du SiO₂, Si₃N₄, Al₂O₃ (notamment dans le cas d'OLED), entre autres. Elle peut présenter une épaisseur de l'ordre de quelques centaines de nanomètres, par exemple 400nm environ.

En référence à la fig.1D, on réalise les motifs de potentiel de surface M1, par polarisation électrostatique localisée de la couche diélectrique 26, qui forme alors la couche diélectrique électret. Pour cela, on place une électrode temporaire 2 au-dessus de la couche diélectrique 26, et de préférence au contact de celle-ci. Notons que cette électrode temporaire 2 peut être formée d'une plaque conductrice rigide, voire d'une couche d'un liquide électriquement conducteur (métal, électrolyte...), entre autres. On applique une différence de potentiel entre l'électrode temporaire 2 d'une part, et les seules couches d'électrode supérieure E1 d'autre part. Cette différence de potentiel peut être de l'ordre de quelques dizaines ou centaines de volts, par exemple comprise entre 10V et 200V. Lors de cette étape, seules les couches d'électrode supérieure E1 sont activées, et non pas les autres couches d'électrode supérieure E2 et E3. Des motifs de potentiel de surface non nul M1 sont formés de manière localisée au niveau de la face supérieure de la couche diélectrique électret 26, en regard des seules diodes D1, et non pas en regard des diodes D2 et D3. On retire ensuite l'électrode temporaire 2. Notons que, lors de cette étape, les couches d'électrode inférieure 21 restent non polarisées, de sorte que les diodes D1, D2, D3 sont inactives.

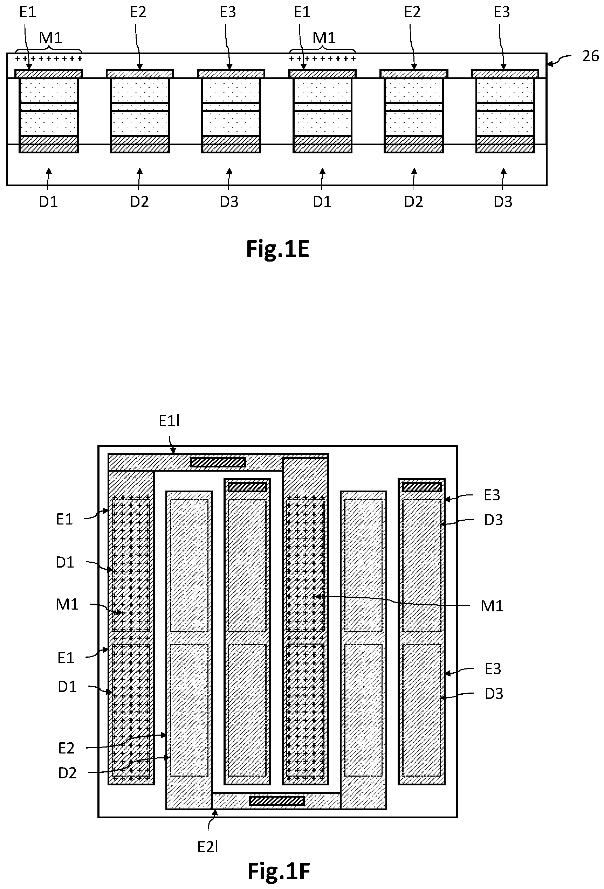

Les fig. 1E et 1F illustrent la structure obtenue. Les motifs de potentiel de surface M1 sont présents uniquement en regard des couches d'électrode supérieure E1. Autrement dit, la couche diélectrique électret 26 présente un potentiel de surface sensiblement nul partout, sauf en regard des couches d'électrode supérieure E1. Notons que, dans cet exemple, les motifs de potentiel de surface M1 peuvent ne pas s'étendre en regard de la bande conductrice latérale E1I de connexion des couches d'électrode supérieure E1.

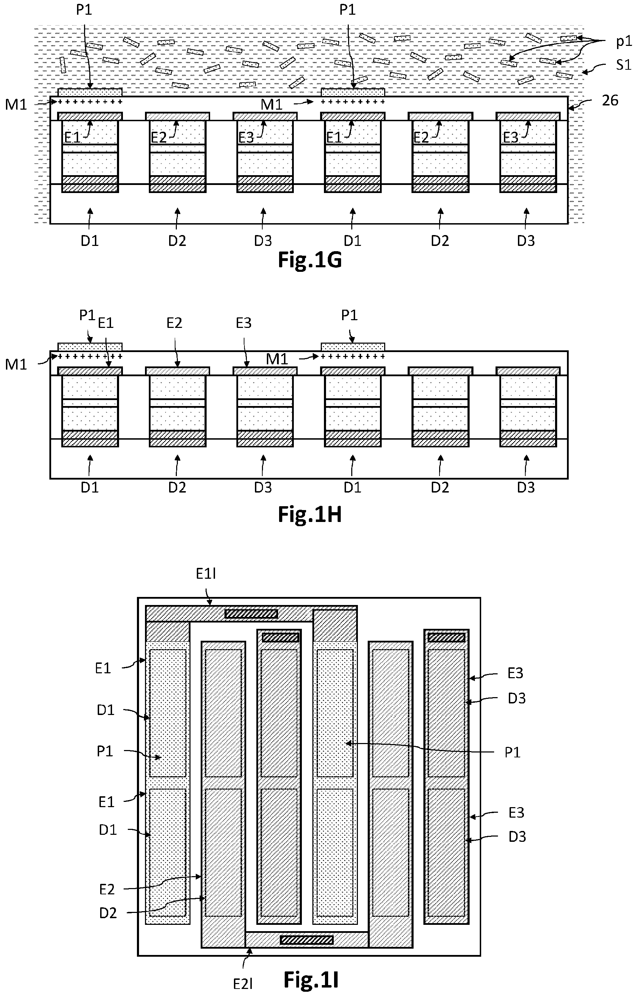

En référence à la fig.1G, on réalise ensuite les premières portions de conversion de couleur P1, par dépôt localisé de premières particules photoluminescentes p1 sur la couche diélectrique électret 26, en regard des seuls motifs de potentiel de surface M1. Pour cela, on opère d'une manière similaire à ce qui est décrit dans les documents WO2014/136023 et WO2021/023656. Ainsi, on met une solution colloïdale S1 contenant les premières particules photoluminescentes p1 au contact de la face supérieure de la couche diélectrique électret 26. Les particules photoluminescentes p1 sont adaptées à convertir la lumière bleue en une lumière rouge. On peut ainsi plonger tout l'empilement dans la solution colloïdale S1, ou déposer une goutte d'une telle solution sur la couche diélectrique électret 26. Du fait du potentiel de surface non nul situé dans les motifs M1, un champ électrique non uniforme est généré qui provoque un dépôt localisé des particules photoluminescentes p1 par électrophorèse ou diélectrophorèse. Aussi, les particules photoluminescentes p1 se déposent essentiellement en regard des premiers motifs M1 (et donc en regard des diodes D1), et sensiblement pas hors des motifs M1 (i.e. pas en regard des diodes D2 et D3). Le temps de contact de la solution colloïdale S1 sur la couche diélectrique électret 26 dépend notamment de la quantité de particules photoluminescentes p1 à déposer et donc de l'épaisseur souhaitée des portions de conversion de couleur P1, ainsi que de la valeur du potentiel de surface. A titre d'exemple, l'épaisseur des portions de conversion de couleur P1 peut être de l'ordre de quelques centaines de nanomètres, par exemple égale à 400nm environ. On retire ensuite la solution colloïdale S1 et on peut sécher la couche diélectrique électret.

Les fig. 1H et 1I illustrent la structure obtenue. Les portions de conversion de couleur P1 sont présentes uniquement en regard des couches d'électrode supérieure E1 et donc des diodes D1. Elles ne s'étendent pas en regard des diodes D2 et D3. On obtient ainsi les pixels rouges dont le positionnement relatif des portions de conversion de couleur P1 vis-à-vis des diodes D1 est optimal. Les portions P1 ne s'étendent pas en regard des diodes D2 et D3, et recouvrent avantageusement entièrement les diodes D1 dans le plan XY. Notons que, ici, les portions de conversion de couleur P1 forment des plots distincts, un même plot s'étendant toutefois en regard de plusieurs diodes D1 adjacentes. Une encapsulation en couche fine (par ex. en Al₂O₃) des portions de conversion de couleur P1 peut être effectuée.

On peut ensuite réitérer les étapes précédentes pour réaliser les portions de conversion de couleur P2 situées en regard des diodes D2, formant ici des pixels verts. En effet, les portions de conversion de couleur P1 sont adaptées ici à convertir une lumière bleue (longueur d'onde comprise entre 440nm et 490nm environ) en une lumière rouge (longueur d'onde comprise entre 600nm et 650nm). En revanche, les portions de conversion de couleur P2 sont adaptées ici à convertir la lumière bleue en une lumière verte (longueur d'onde comprise entre 495nm et 560nm environ).

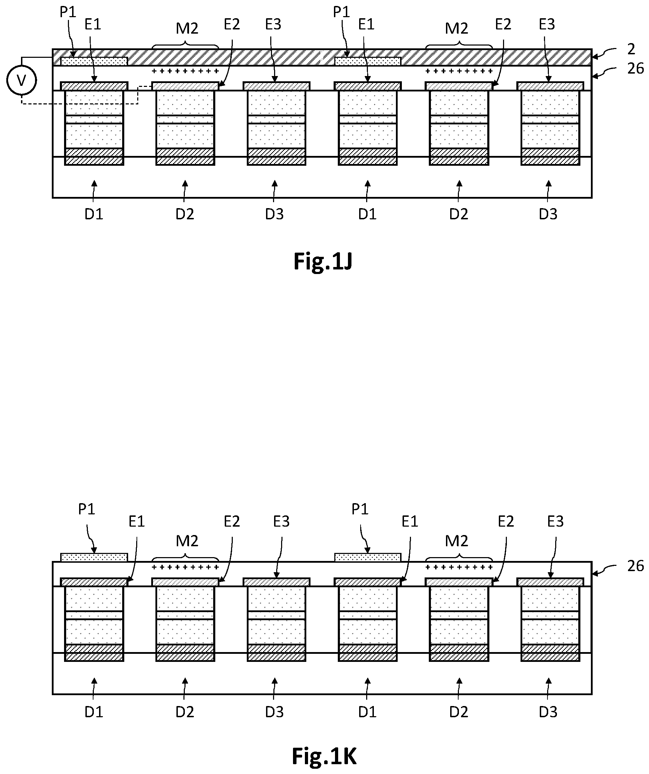

En référence à la fig.1J, on réalise les motifs de potentiel de surface M2, par polarisation électrostatique localisée de la couche diélectrique électret 26. Pour cela, on place à nouveau une électrode temporaire 2 au-dessus de la couche diélectrique électret 26, et de préférence au contact de celle-ci. Dans cet exemple, cette électrode temporaire 2 est une couche d'un métal liquide (ou d'un électrolyte), mais il peut évidemment s'agir d'une plaque conductrice rigide. On applique une différence de potentiel entre l'électrode temporaire 2 d'une part, et les seules couches d'électrode supérieure E2 d'autre part. Cette différence de potentiel peut être par exemple comprise entre 10V et 200V. Lors de cette étape, seules les couches d'électrode supérieure E2 sont activées, et non pas les autres couches d'électrode supérieure E1 et E3. Des motifs de potentiel de surface non nul M2 sont formés de manière localisée au niveau de la face supérieure de la couche diélectrique électret 26, en regard des seules diodes D2, et non pas en regard des diodes D1 et D3. On retire ensuite l'électrode temporaire.

La fig.1K illustre la structure obtenue, où la couche diélectrique électret 26 comporte les seuls motifs de potentiel de surface M2. En effet, les motifs M1 peuvent avoir disparu après une durée prédéfinie, ou peuvent avoir été supprimés (par ex. lors d'un bain de nettoyage). Ils peuvent également être présents mais être écrantés par les plots P1 en regard. Les motifs de potentiel de surface M2 sont présents uniquement en regard des couches d'électrode supérieure E2. Dans cet exemple, la couche diélectrique électret 26 présente un potentiel de surface sensiblement nul partout, sauf en regard des couches d'électrode supérieure E2. Notons que, dans cet exemple, les motifs de potentiel de surface M2 ne s'étendent pas en regard de la bande conductrice latérale E2I de connexion des couches d'électrode supérieure E2, dans la mesure où l'électrode temporaire 2 n'a pas été disposée au-dessus de celle-ci.

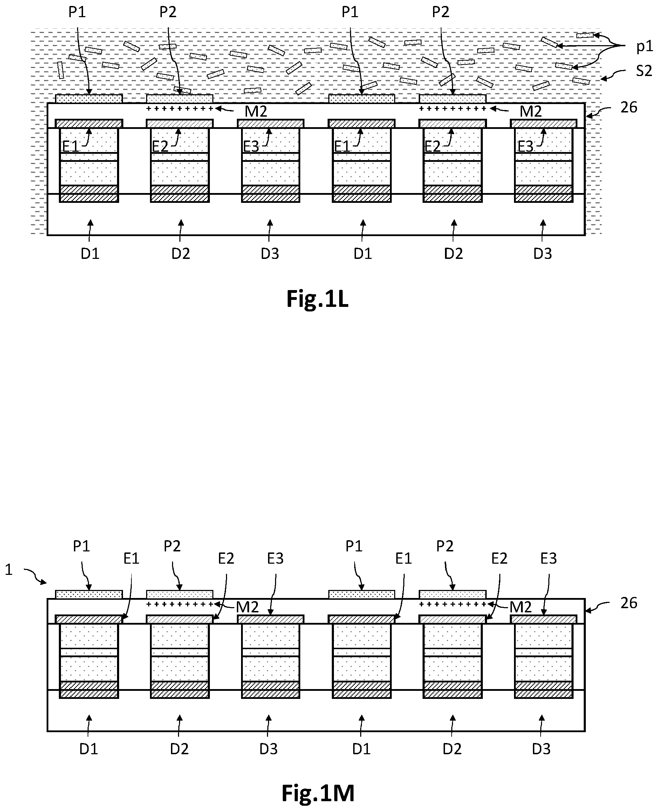

En référence à la fig.1L, on réalise ensuite les portions de conversion de couleur P2, par dépôt localisé de premières particules photoluminescentes p2 sur la couche diélectrique électret 26, en regard des seuls motifs de potentiel de surface M2. Pour cela, on opère comme précédemment, en mettant une solution colloïdale S2 contenant les particules photoluminescentes p2 au contact de la face supérieure de la couche diélectrique électret 26. Les particules photoluminescentes p2 sont différentes des particules p1 en ce qu'elles sont adaptées à convertir la lumière bleue en une lumière verte. On peut ainsi plonger tout l'empilement dans la solution colloïdale S2, ou déposer une goutte d'une telle solution sur la couche diélectrique électret. Du fait du potentiel de surface non nul situé dans les motifs de potentiel de surface M2, un champ électrique non uniforme est généré qui provoque un dépôt localisé des particules photoluminescentes p2 par électrophorèse ou diélectrophorèse. Aussi, les particules photoluminescentes p2 se déposent essentiellement en regard des motifs M2 (et donc en regard des diodes D2), et sensiblement pas hors des motifs M2 (i.e. pas en regard des diodes D1 et D3). Le temps de contact de la solution colloïdale S2 sur la couche diélectrique électret 26 dépend notamment de la quantité de particules photoluminescentes p2 à déposer et donc de l'épaisseur souhaitée des portions de conversion de couleur P2. A titre d'exemple, l'épaisseur des portions de conversion de couleur P2 peut être de l'ordre de quelques centaines de nanomètres, par exemple égale à 400nm environ. On retire ensuite la solution colloïdale S2 et on peut sécher la couche diélectrique électret 26. Une couche d'encapsulation peut être déposée.

La fig.1M illustre le dispositif optoélectronique 1 obtenu. Les portions de conversion de couleur P1 sont présentes uniquement en regard des diodes D1 et définissent les pixels rouges ; les portions de conversion de couleur P2 sont situées uniquement en regard des diodes D2 et définissent les pixels verts. Les diodes D3 ne sont ici pas recouvertes par des portions de conversion de couleur, formant ainsi des pixels bleus. On obtient ainsi un dispositif à matrice de pixels RGB, où les portions de conversion de couleur P1, P2 ont été déposées de manière localisée et autoalignée en regard des diodes voulues, par électrophorèse ou diélectrophorèse sur la couche diélectrique électret 26 dont la polarisation localisée a été obtenue en tirant parti des couches d'électrode supérieure E1, E2 de polarisation des diodes. Ainsi, on n'a pas eu besoin de réaliser des électrodes supérieures dédiées à la réalisation des portions de conversion de lumière, qui soient différentes des électrodes supérieures de polarisation des diodes lors du fonctionnement du dispositif optoélectronique 1.

On évite donc d'avoir recours à une étape d'injection localisée de charges électriques dans une couche diélectrique initialement sans charges électriques, au moyen d'une pointe AFM ou d'un tampon conducteur. Aussi, le procédé est rapide et la réalisation des portions de conversion de lumière est spatialement précise, même dans le cadre d'une matrice de diodes réalisées à partir de substrat de grande dimension (par exemple 200 mm) et/ou dont le pas pixel est très petit (par exemple 5 µm).

La figure 2A est une vue de dessus d'un dispositif optoélectronique 1 selon une variante de la fig.1B. La surface émissive du dispositif optoélectronique 1 est délimitée par les traits en pointillé.

Ici, chaque couche d'électrode supérieure E1 des différents pixels est raccordée électriquement à un même plot de connexion 3₁ par une bande conductrice latérale E1I qui s'étend en bordure de la surface émissive. Ce plot de connexion 3₁ peut être un via conducteur qui traverse la couche diélectrique de remplissage 25 de la structure optoélectronique pour venir au contact d'un plot conducteur 11 du substrat de commande 10 (cf. fig.1A). De même, chaque couche d'électrode supérieure E2 est raccordée électriquement à un même plot de connexion 3₂ par une bande conductrice latérale E2I. Ce plot de connexion 3₂ peut également être un via conducteur connecté au substrat de commande 10.

De plus, dans cet exemple, chaque couche d'électrode supérieure E3 vient au contact d'un via conducteur 3₃ connecté au substrat de commande 10. Ici, les diodes D3 ne sont pas recouvertes par des portions de conversion de lumière dans la mesure où les pixels sont ici des pixels bleus.

Ainsi, lors de l'étape de dépôt localisé et autoaligné des particules photoluminescentes p1, les couches d'électrode supérieure E1 sont toutes connectées entre elles et polarisées de manière simultanée, tandis que les couches d'électrode supérieure E2 et E3 sont non polarisées. Et lors de l'étape de dépôt localisé des particules photoluminescentes p2, les couches d'électrode supérieure E2 sont toutes connectées entre elles et polarisées de manière simultanée, tandis que les couches d'électrode supérieure E1 et E3 sont non polarisées.

Enfin, au terme de la fabrication du dispositif optoélectronique 1, les couches d'électrode supérieure E1 et E2 peuvent être connectées entre elles pour former une électrode supérieure commune aux diodes D1 et D2. Cela peut être effectué au moyen d'une bande conductrice latérale E12I, qui s'étend ici de la bande conductrice latérale E1I des couches E1 en direction d'une bande conductrice latérale E2I des couches E2. Un plot conducteur 4 (trait pointillé) peut ensuite être déposé pour connecter la bande conductrice latérale d'interconnexion E12I à la bande conductrice latérale E2I. Il peut s'agir d'une pâte conductrice déposée par une technique de type jet d'encre. Ainsi, les couches d'électrode supérieure E1 et E2 forment une même électrode supérieure interdigitée qui peut être portée à un potentiel électrique, lors de l'activation des diodes D1 et D2. L'activation sélective des diodes D1 et D2 peut ensuite être effectuée par la polarisation de telle ou telle couche d'électrode inférieure 21.

Notons par ailleurs, que les couches d'électrode supérieure E3 peuvent également être connectées aux couches d'électrode supérieure E1 et E2, de manière à former une même électrode supérieure commune interdigitée. Différentes techniques classiques peuvent être utilisées (dépôt de plots conducteurs pour assurer l'interconnexion, tir laser, etc...).

La figure 2B est une vue de dessus de plusieurs dispositifs optoélectroniques 1 identiques selon une variante de réalisation, qui illustre une manière de connecter les bandes latérales à des bandes périphériques de polarisation.

Dans cet exemple, le procédé porte sur la fabrication collective et simultanée de dispositifs optoélectroniques 1 identiques, à l'échelle d'un même substrat 5 (ou *wafer* en anglais) de grande dimension, par exemple présentant un diamètre de 200 ou 300mm.

Ici, lors de la réalisation des portions de conversion de couleur P1, les couches d'électrode supérieure E1 sont toutes connectées entre elles et sont polarisées ensemble lors de l'étape de la fig.1D. Ainsi, une même bande conductrice latérale E1I s'étend le long de plusieurs dispositifs optoélectroniques adjacents (cf. fig.2A), et vient au contact d'une bande conductrice latérale principale E1Ip située en bordure du substrat. Notons que l'électrode temporaire 2 s'étend, de préférence, de manière à recouvrir continûment toutes les matrices de diodes.

De même, lors de la réalisation des portions de conversion de couleur P2, les couches d'électrode supérieure E2 sont toutes connectées entre elles et sont polarisées ensemble lors de l'étape de la fig.1J. Pour cela, une même bande conductrice latérale E2I s'étend le long de plusieurs dispositifs optoélectroniques adjacents (cf. fig.2A), et vient au contact d'une bande conductrice latérale principale E2lp située en bordure du substrat.

A la fin du procédé de fabrication, le substrat 5 est découpé pour individualiser les dispositifs optoélectroniques 1.

Aussi, le procédé de fabrication permet de réaliser les portions de conversion de couleur P1, P2 par dépôt localisé et autoaligné des particules photoluminescentes vis-à-vis des diodes voulues, à l'échelle du substrat 5.

Les figures 3A à 3D illustrent différentes étapes d'un procédé de fabrication d'un dispositif optoélectronique 1 selon un autre mode de réalisation. Ici, le dispositif optoélectronique 1 se distingue de celui des figures 1A et suivantes essentiellement en ce que les diodes D1, D2, D3 sont des diodes électroluminescentes organiques, ici en émission par le haut (*top emission* en anglais). Le dispositif optoélectronique peut ainsi être un écran couleur OLED présentant une résolution élevée (petits pixels) et une forte luminance liée à un rendement quantique important. Dans cet exemple, on aura une couche émettrice OLED de couleur bleue, déposée sur tous les pixels, et la coloration se fera par dépôt sélectif de convertisseurs sur les pixels verts et rouges, respectivement.

En référence à la fig.3A, on fournit un substrat de commande 10 (CMOS) ayant des plots de connexion 11 qui affleurent la face supérieure. Ces plots de connexion 11 forment les couches d'électrode inférieure d'une part, et d'autres 12.1, 12.2 (non représenté), 12.3 sont destinés à assurer la polarisation électrique des couches d'électrode supérieure E1, E2, E3.

En référence à la fig.3B, on réalise ensuite un empilement 30 de couches semiconductrices organiques, qui s'étend sur le substrat de commande 10 et recouvre les couches d'électrode inférieure 11. Classiquement, il s'agit d'un empilement d'une couche HTL, de couches d'émission, et d'une couche ETL. Puis on réalise des couches d'électrode supérieure E1, E2 et E3 sur l'empilement semiconductrice organique 30. Les couches d'électrode supérieure E1 sont connectées ici à un même plot de connexion 12.1, tout comme les couches d'électrode supérieure E2 à un plot de connexion 12.2 (non représenté).

En référence à la fig.3C, on dépose ensuite un film mince d'encapsulation 26 (TFE en anglais), qui recouvre l'empilement semiconductrice organique 30 et les couches d'électrode supérieure E1, E2 et E3. Cette couche TFE 26 est réalisée en un matériau diélectrique, et est destinée à former la couche diélectrique électret. A noter que la TFE peut servir d'électret selon une variante. Dans le cas général, on a la TFE puis un électret au-dessus.

En référence à la fig.3D, on réalise ensuite les plots de conversion de couleur P1 et P2, lesquels sont situés en regard, respectivement, des couches d'électrode supérieure E1 et E2. Ces plots de conversion de couleur sont réalisés comme décrits précédemment en référence aux figures 1A et suivantes. Ainsi, on obtient un dispositif optoélectronique à diodes organiques, qui peut présenter une résolution élevée, avec des plots de conversion de couleur P1 et P2 réalisés de manière localisée et autoalignée au moyen des couches d'électrode supérieure E1 et E2.

Des modes de réalisation particuliers viennent d'être décrits, mais l'invention est définie par les revendications attenantes.

## Revendications

1. Procédé de fabrication d'un dispositif optoélectronique (1), lequel comporte :
• une matrice de diodes (D1, D2, D3), présentant des faces arrière et avant opposées l'une à l'autre, la face avant étant destinée à recevoir ou transmettre un rayonnement lumineux ;
• une matrice de portions de conversion de couleur (P1, P2) disposée sur la face avant, dont des premières portions de conversion de couleur (P1) disposées en regard de diodes dites premières diodes (D1) de la matrice de diodes ;
∘ le procédé comportant les étapes suivantes :
∘ fournir une structure optoélectronique comportant : la matrice de diodes (D1, D2, D3) ; au moins une couche d'électrode inférieure (21) disposée au niveau de la face arrière et adaptée à polariser les diodes ; et des couches d'électrode supérieure (E1, E2, E3) disposées au niveau de la face avant et adaptées à polariser les diodes, dont des premières couches d'électrode supérieure (E1) adaptées à polariser les premières diodes (D1) et distinctes des autres couches d'électrode supérieure (E2, E3) ;
∘ déposer une couche diélectrique (26), dont une face supérieure opposée à la face avant présente un potentiel de surface sensiblement nul, recouvrant la matrice de diodes (D1, D2, D3) et les couches d'électrode supérieure (E1, E2, E3) ;
∘ appliquer une différence de potentiel entre, d'une part une électrode temporaire (2) disposée sur la couche diélectrique (26), et d'autre part les premières couches d'électrode supérieure (E1), se traduisant par la formation de premiers motifs (M1) à potentiel de surface non nul dans la couche diélectrique (26) située uniquement en regard des premières couches d'électrode supérieure (E1) ; puis retirer l'électrode temporaire (2) ;
∘ réaliser les premières portions de conversion de couleur (P1), par mise en contact de la couche diélectrique (26) avec une première solution colloïdale (S1) contenant des premières particules photoluminescentes (p1), lesquelles se déposent sur la couche diélectrique (26) uniquement en regard des premiers motifs (M1) à potentiel de surface non nul, formant ainsi les premières portions de conversion de couleur (P1).

2. Procédé de fabrication selon la revendication 1,
• la matrice de portions de conversion de couleur comportant des deuxièmes portions de conversion de couleur (P2), distinctes des premières portions de conversion de couleur (P1), et disposées en regard de diodes dites deuxièmes diodes (D2) de la matrice de diodes ;
• la structure optoélectronique comportant, parmi les couches d'électrode supérieure (E1, E2, E3), des deuxièmes couches d'électrode supérieure (E2) adaptées à polariser les deuxièmes diodes (D2) ;
∘ le procédé comportant, à la suite de la réalisation des deuxièmes portions de conversion de couleur (P2), les étapes suivantes :
∘ appliquer une différence de potentiel entre, d'une part une électrode temporaire (2) disposée sur la couche diélectrique (26), et d'autre part les deuxièmes couches d'électrode supérieure (E2), se traduisant par la formation de deuxièmes motifs (M2) à potentiel de surface non nul dans la couche diélectrique (26) située uniquement en regard des deuxièmes couches d'électrode supérieure (E2) ; puis retirer l'électrode temporaire (2) ;
∘ réaliser les deuxièmes portions de conversion de couleur (P2), par mise en contact de la couche diélectrique (26) avec une deuxième solution colloïdale (S2) contenant des deuxièmes particules photoluminescentes (p2) distinctes des premières particules photoluminescentes (p1), lesquelles se déposent sur la couche diélectrique (26) uniquement en regard des deuxièmes motifs (M2) à potentiel de surface non nul, formant ainsi les deuxièmes portions de conversion de couleur (P2).

3. Procédé de fabrication selon la revendication 1 ou 2, dans lequel chaque couche d'électrode supérieure (E1, E2, E3) recouvre entièrement la diode au-dessus de laquelle elle est située.

4. Procédé de fabrication selon l'une quelconque des revendications 1 à 3, dans lequel, lors de l'étape d'application d'une différence de potentiel entre l'électrode temporaire (2) et les couches d'électrode supérieure (E1, E2), les couches d'électrode inférieure (21) sont non polarisées.

5. Procédé de fabrication selon l'une quelconque des revendications 1 à 4, dans lequel, lors de l'étape d'application d'une différence de potentiel entre l'électrode temporaire (2) et les couches d'électrode supérieure (E1, E2), lesdites couches d'électrode supérieure alors polarisées sont connectées entre elles.

6. Procédé de fabrication selon l'une quelconque des revendications 1 à 5, dans lequel les diodes sont au contact de couches d'électrode inférieure (21), les couches d'électrode inférieure (21) étant distinctes les unes des autres, de manière à pouvoir activer chaque diode de manière sélective.

7. Procédé de fabrication selon l'une quelconque des revendications 1 à 6, comportant, après la réalisation des portions de conversion de couleur (P1, P2), une étape de connexion des premières et deuxièmes couches d'électrode supérieure (E1, E2, E3) entre elles.

8. Procédé de fabrication selon l'une quelconque des revendications 1 à 7, comportant, après la réalisation des portions de conversion de couleur (P1, P2), une étape de connexion de toutes les couches d'électrode supérieure (E1, E2, E3) entre elles.

9. Procédé de fabrication selon l'une quelconque des revendications 1 à 8, dans lequel les diodes présentent des propriétés d'émission ou d'absorption d'un rayonnement lumineux identiques entre elles.

10. Procédé de fabrication selon l'une quelconque des revendications 1 à 9, dans lequel les diodes sont réalisées à base d'un composé semiconducteur organique ou inorganique.

11. Procédé de fabrication collective et simultanée de plusieurs dispositifs optoélectroniques (1) à partir d'un même substrat (5), comportant la mise en œuvre simultanée des étapes du procédé selon l'une quelconque des revendications précédentes pour chaque dispositif optoélectronique (1).

12. Procédé de fabrication collective selon la revendication 11, dans lequel, lors de l'étape d'application d'une différence de potentiel entre l'électrode temporaire (2) et les couches d'électrode supérieure (E1, E2), l'électrode temporaire (2) recouvre continûment toutes les matrices de diodes, et dans lequel lesdites couches d'électrode supérieure alors polarisées sont connectées entre elles.

## Patentansprüche

1. Verfahren zur Fertigung einer optoelektronischen Vorrichtung (1), die Folgendes aufweist:
• eine Diodenmatrix (D1, D2, D3), die einander gegenüberliegende Rückseiten und Vorderseiten beinhaltet, wobei die Vorderseite dazu bestimmt ist, eine Lichtstrahlung zu empfangen oder zu übertragen;
• eine Matrix aus Farbumwandlungsabschnitten (P1, P2), die auf der Vorderseite angeordnet ist, darunter erste Farbumwandlungsabschnitte (P1), die gegenüber ersten Dioden (D1) der Diodenmatrix angeordnet sind;
∘ wobei das Verfahren ferner die folgenden Schritte aufweist:
∘ Bereitstellen einer optoelektronischen Struktur, die Folgendes umfasst: die Diodenmatrix (D1, D2, D3); mindestens eine untere Elektrodenschicht (21), die auf der Rückseite angeordnet und geeignet ist, die Dioden zu polarisieren; und obere Elektrodenschichten (E1, E2, E3), die auf der Vorderseite angeordnet und geeignet sind, die Dioden zu polarisieren, darunter erste obere Elektrodenschichten (E1), die geeignet sind, die ersten Dioden (D1) zu polarisieren, und von den anderen oberen Elektrodenschichten (E2, E3) getrennt sind;
∘ Ablagern einer dielektrischen Schicht (26), deren der Vorderseite gegenüberliegende Oberseite ein Oberflächenpotenzial von im Wesentlichen Null beinhaltet und die die Diodenmatrix (D1, D2, D3) und die oberen Elektrodenschichten (E1, E2, E3) bedeckt;
∘ Anlegen einer Potenzialdifferenz zwischen einerseits einer temporären Elektrode (2), die auf der dielektrischen Schicht (26) angeordnet ist, und andererseits den ersten oberen Elektrodenschichten (E1), was zur Bildung erster Muster (M1) mit einem Oberflächenpotenzial ungleich Null in der dielektrischen Schicht (26) führt, die sich ausschließlich gegenüber den ersten oberen Elektrodenschichten (E1) befindet; dann Entfernen der temporären Elektrode (2);
∘ Herstellen der ersten Farbumwandlungsabschnitte (P1) durch Inkontaktbringen der dielektrischen Schicht (26) mit einer ersten kolloidalen Lösung (S1), die erste photolumineszierende Partikel (p1) enthält, die sich auf der dielektrischen Schicht (26) nur gegenüber den ersten Mustern (M1) mit einem Oberflächenpotenzial ungleich Null ablagern und so die ersten Farbumwandlungsabschnitte (P1) bilden.

2. Fertigungsverfahren nach Anspruch 1,
• wobei die Matrix aus Farbumwandlungsabschnitten zweite Farbumwandlungsabschnitte (P2) aufweist, die sich von den ersten Farbumwandlungsabschnitten (P1) unterscheiden und gegenüber zweiten Dioden (D2) der Diodenmatrix angeordnet sind;
• wobei die optoelektronische Struktur, unter den oberen Elektrodenschichten (E1, E2, E3), zweite obere Elektrodenschichten (E2) aufweist, die geeignet sind, die zweiten Dioden (D2) zu polarisieren;
∘ wobei das Verfahren nach dem Herstellen der zweiten Farbumwandlungsabschnitte (P2) folgende Schritte aufweist:
∘ Anlegen einer Potenzialdifferenz zwischen einerseits einer temporären Elektrode (2), die auf der dielektrischen Schicht (26) angeordnet ist, und andererseits den zweiten oberen Elektrodenschichten (E2), was sich in der Bildung von zweiten Mustern (M2) mit einem Oberflächenpotenzial ungleich Null in der nur gegenüber den zweiten oberen Elektrodenschichten (E2) befindlichen dielektrischen Schicht (26) niederschlägt; dann Entfernen der temporären Elektrode (2);
∘ Herstellen der zweiten Farbumwandlungsabschnitte (P2) durch Inkontaktbringen der dielektrischen Schicht (26) mit einer zweiten kolloidalen Lösung (S2), die zweite photolumineszierende Partikel (p2) enthält, die sich von den ersten photolumineszierenden Partikeln (p1) unterscheiden, und sich auf der dielektrischen Schicht (26) nur gegenüber den zweiten Mustern (M2) mit einem Oberflächenpotenzial ungleich Null ablagern, wodurch die zweiten Farbumwandlungsabschnitte (P2) gebildet werden.

3. Fertigungsverfahren nach Anspruch 1 oder 2, wobei jede obere Elektrodenschicht (E1, E2, E3) die Diode, über der sie sich befindet, vollständig bedeckt.

4. Fertigungsverfahren nach einem der Ansprüche 1 bis 3, wobei bei dem Schritt des Anlegens einer Potenzialdifferenz zwischen der temporären Elektrode (2) und den oberen Elektrodenschichten (E1, E2) die unteren Elektrodenschichten (21) unpolarisiert sind.

5. Fertigungsverfahren nach einem der Ansprüche 1 bis 4, wobei bei dem Schritt des Anlegens einer Potenzialdifferenz zwischen der temporären Elektrode (2) und den oberen Elektrodenschichten (E1, E2) die dann polarisierten oberen Elektrodenschichten miteinander verbunden sind.

6. Fertigungsverfahren nach einem der Ansprüche 1 bis 5, wobei die Dioden mit unteren Elektrodenschichten (21) in Kontakt sind, wobei die unteren Elektrodenschichten (21) voneinander getrennt sind, so dass jede Diode selektiv aktiviert werden kann.

7. Fertigungsverfahren nach einem der Ansprüche 1 bis 6, das nach der Herstellung der Farbumwandlungsabschnitte (P1, P2) einen Schritt des Verbindens der ersten und zweiten oberen Elektrodenschichten (E1, E2, E3) miteinander aufweist.

8. Fertigungsverfahren nach einem der Ansprüche 1 bis 7, das nach der Herstellung der Farbumwandlungsabschnitte (P1, P2) einen Schritt des Verbindens aller oberen Elektrodenschichten (E1, E2, E3) untereinander aufweist.

9. Fertigungsverfahren nach einem der Ansprüche 1 bis 8, wobei die Dioden untereinander identische Eigenschaften zur Emission oder Absorption einer Lichtstrahlung beinhalten.

10. Fertigungsverfahren nach einem der Ansprüche 1 bis 9, wobei die Dioden auf Grundlage einer organischen oder anorganischen Halbleiterverbindung hergestellt sind.

11. Gemeinsames und gleichzeitiges Fertigungsverfahren mehrerer optoelektronischer Vorrichtungen (1) aus einem gleichen Substrat (5), das die gleichzeitige Durchführung der Verfahrensschritte nach einem der vorhergehenden Ansprüche für jede optoelektronische Vorrichtung (1) aufweist.

12. Gemeinsames Fertigungsverfahren nach Anspruch 11, wobei bei dem Schritt des Anlegens einer Potenzialdifferenz zwischen der temporären Elektrode (2) und den oberen Elektrodenschichten (E1, E2) die temporäre Elektrode (2) kontinuierlich alle Diodenmatrizen bedeckt, und wobei die dann polarisierten oberen Elektrodenschichten miteinander verbunden sind.

## Claims

1. Method for manufacturing an optoelectronic device (1), which includes:
• an array of diodes (D1, D2, D3), having mutually opposite rear and front faces, the front face being intended to receive or transmit light radiation;
• an array of colour conversion portions (P1, P2) disposed on the front face, including first colour conversion portions (P1) disposed facing diodes referred to as first diodes (D1) of the diode array;
∘ the method including the following steps:
∘ providing an optoelectronic structure including: the array of diodes (D1, D2, D3); at least one lower electrode layer (21) disposed at the rear face and adapted to polarise the diodes; and upper electrode layers (E1, E2, E3) disposed at the front face and adapted to polarise the diodes, including first upper electrode layers (E1) adapted to polarise the first diodes (D1) and distinct from the other upper electrode layers (E2, E3);
∘ depositing a dielectric layer (26), of which an upper face opposite the front face has a substantially zero surface potential, covering the array of diodes (D1, D2, D3) and the upper electrode layers (E1, E2, E3);
∘ applying a potential difference between, on one hand, a temporary electrode (2) disposed on the dielectric layer (26), and, on the other, the first upper electrode layers (E1), resulting in the formation of first patterns (M1) with non-zero surface potential in the dielectric layer (26) located only facing the first upper electrode layers (E1); then removing the temporary electrode (2);
∘ producing the first colour conversion portions (P1), by contacting the dielectric layer (26) with a first colloidal solution (S1) containing first photoluminescent particles (p1), which are deposited on the dielectric layer (26) only facing the first patterns (M1) with non-zero surface potential, thus forming the first colour conversion portions (P1).

2. Manufacturing method according to claim 1,
• the array of colour conversion portions including second colour conversion portions (P2), distinct from the first colour conversion portions (P1), and disposed facing diodes referred to as second diodes (D2) of the diode array;
• the optoelectronic structure including, among the upper electrode layers (E1, E2, E3), second upper electrode layers (E2) adapted to polarise the second diodes (D2);
∘ the method including, after producing the second colour conversion portions (P2), the following steps:
∘ applying a potential difference between, on one hand, a temporary electrode (2) disposed on the dielectric layer (26), and, on the other, the second upper electrode layers (E2), resulting in the formation of second patterns (M2) with non-zero surface potential in the dielectric layer (26) located only facing the second upper electrode layers (E2); then removing the temporary electrode (2);
∘ producing the second colour conversion portions (P2), by contacting the dielectric layer (26) with a second colloidal solution (S2) containing second photoluminescent particles (p2) distinct from the first photoluminescent particles (p1), which are deposited on the dielectric layer (26) only facing the second patterns (M2) with non-zero surface potential, thus forming the second colour conversion portions (P2).

3. Manufacturing method according to claim 1 or 2, wherein each upper electrode layer (E1, E2, E3) entirely covers the diode on top of which it is located.

4. Manufacturing method according to any of claims 1 to 3, wherein, during the step of applying a potential difference between the temporary electrode (2) and the upper electrode layers (E1, E2), the lower electrode layers (21) are non-polarised.

5. Manufacturing method according to any of claims 1 to 4, wherein, during the step of applying a potential difference between the temporary electrode (2) and the upper electrode layers (E1, E2), said upper electrode layers then polarised are interconnected.

6. Manufacturing method according to any of claims 1 to 5, wherein the diodes are in contact with lower electrode layers (21), the lower electrode layers (21) being distinct from each other, so as to be able to activate each diode selectively.

7. Manufacturing method according to any of claims 1 to 6, including, after producing the colour conversion portions (P1, P2), a step of interconnecting the first and second upper electrode layers (E1, E2, E3).

8. Manufacturing method according to any of claims 1 to 7, including, after producing the colour conversion portions (P1, P2), a step of interconnecting all of the upper electrode layers (E1, E2, E3).

9. Manufacturing method according to any of claims 1 to 8, wherein the diodes have mutually identical light radiation emission or absorption properties.

10. Manufacturing method according to any one of claims 1 to 9, wherein the diodes are produced based on an organic or inorganic semiconductor compound.

11. Method for collectively and simultaneously manufacturing several optoelectronic devices (1) from the same substrate (5), including the simultaneous implementation of the steps of the method according to any of the preceding claims for each optoelectronic device (1).

12. Collective manufacturing method according to claim 11, wherein, during the step of applying a potential difference between the temporary electrode (2) and the upper electrode layers (E1, E2), the temporary electrode (2) continuously covers all the diode arrays, and wherein said upper electrode layers then polarised are interconnected.
